# EUROPÄISCHE PATENTANMELDUNG

(11) **EP 2 119 679 A1**
(43) Veröffentlichungstag der Anmeldung: **18.11.2009**
(21) Anmeldenummer: 08405137.4
(22) Anmeldetag: 16.05.2008
(51) Int. Cl.: C03B 33/02, C03B 33/037, C03B 33/07

(54) **Verfahren zum Bearbeiten eines Laminats**

(71) Anmelder: 3S Swiss Solar Systems AG, 3250 Lyss (CH); Güdel Group AG, 4900 Langenthal (CH)
(72) Erfinder: Blanchet, Marcel, 8172 Niederglatt (CH); Kappaun, Roland, 88690 Uhldingen-Mühlhofen (DE); Zulauf, Walter, 4932 Gutenburg (CH); Kurt, Hans-Ulrich, 4566 Kriegstetten (CH); Güdel, Rudolf, 4500 Solothurn (CH); Heid, Rudolf, 4542 Luterbach (CH)
(74) Vertreter: Rüfenacht, Philipp Michael

(57) **Zusammenfassung**

Bei einem Verfahren zum Bearbeiten eines Laminats (1), welches mindestens eine feste Platte, insbesondere eine Glasplatte (10), aufweist, wird vor einem Laminationsschritt mindestens eine Ortsmarkierung (115.1, 115.2) an der festen Platte (10) angebracht und mindestens ein Abstands- und/oder Winkelwert der festen Platte (10) in Bezug auf die Ortsmarkierung (115.1, 115.2) bestimmt. Nach dem Laminationsschritt wird das Laminat (1) bearbeitet, wobei das Laminat (1) und ein Bearbeitungswerkzeug (172) in Abhängigkeit der Ortsmarkierung (115.1, 115.2) und des mindestens einen Abstands- und/oder Winkelwerts automatisch relativ zueinander positioniert werden. Vor der Lamination lässt sich die feste Platte (10) ohne weiteres vermessen, ihre Kante ist sowohl mechanisch (z. B. durch einen Fühler) als auch berührungsfrei (z. B. optisch mittels einer Kamera) detektierbar, und es lassen sich gängige, insbesondere automatisierte Verfahren zur Vermessung einsetzen. Nach der Lamination, die ein Erfassen der Kanten der festen Platte (10) erschwert, kann die Bearbeitung gestützt auf die angebrachten Ortsmarkierungen (115.1, 115.2) und den erfassten Abstands- und/oder Winkelwert (bzw. eine Mehrzahl solcher Werte) erfolgen. Es ist somit nicht mehr notwendig, die Kante der festen Platte (10) nach der Lamination noch zu detektieren.

## Beschreibung

### Technisches Gebiet

Die Erfindung betrifft ein Verfahren zum Bearbeiten eines Laminats, welches mindestens eine feste Platte, insbesondere eine Glasplatte, aufweist. Die Erfindung betrifft weiter eine Anlage zum Bearbeiten eines solchen Laminats.

### Stand der Technik

Laminate haben einen weiten Anwendungsbereich und können sehr unterschiedliche Schichtsysteme aufweisen. Eine Gruppe von Laminaten weist eine oder mehrere feste Platten auf, welche dem Laminat Formstabilität verleihen. Als feste Platten dienen oft Glasplatten, insbesondere dann, wenn das Laminat ganz oder teilweise transparent sein soll. Beispiele für solche Laminate sind Verbundgläser, welche bei der Automobil- oder Gebäudeverglasung zum Einsatz kommen.

Eine spezifische Anwendung solcher Laminate sind zudem Solarpanels (auch Solarmodule genannt). Es ist bekannt, solche Solarpanels aufzubauen, indem eine Mehrzahl von mechanisch empfindlichen Solarzellen (photovoltaische Zellen, z. B. Dickschicht-Solarzellen auf der Basis von Silicium) elektrisch miteinander verbunden und in einem Schichtsystem eingeschlossen werden. Das Schichtsystem verleiht mechanische Stabilität und schützt die eingeschlossenen Zellen vor Witterungseinflüssen oder mechanischen Beeinträchtigungen. Das Schichtsystem kann beispielsweise auf einem für die relevanten Anteile der Sonnenstrahlung transparenten Glassubstrat und einer Rückseitenfolie basieren, zwischen welchen die Solarzellen und die sie verbindenden elektrischen Verbinder eingeschlossen sind. Zwischen den genannten Schichten sind Folien aus EVA (Ethylenvinylacetat) oder einem anderen geeigneten Material eingebracht, so dass das Schichtsystem unter dem Einfluss von Wärme und Druck zusammenlaminiert werden kann. Die Solarzellen können von einem Rahmen umschlossen werden.

Bei der Herstellung derartiger Laminate ist es oft notwendig, über die feste Platte überstehende Abschnitte von Laminierschichten bzw. der Rückseitenfolie nach dem Laminieren abzutrennen. Dafür sind mehrere Verfahren bekannt:

So beschreibt die US 4,067,764 (J. S. Walker, W. C. Kittler) ein Solarpanel, bestehend aus einer Glasplatte, zwei PVB-Schichten, zwischen denen Solarzellen angeordnet sind, und einer PET-Schicht, die das Schichtsystem abschliesst. Die PET-Schicht steht über die weiteren Schichten hinaus, so dass sie an einer festen Grundplatte aus Metall befestigt werden kann. Nach dem Laminieren wird der überstehende Teil der PET-Schicht abgeschnitten. Über den Prozessschritt des Abschneidens ist nichts im Detail offenbart. Es ist davon auszugehen, dass das Abschneiden in herkömmlicher Weise manuell erfolgt, z. B. mit Hilfe eines Messers mit scharfer Klinge.

Das manuelle Abschneiden der Randbereiche ist allerdings zeitaufwendig und die Verletzungsgefahr für das Personal ist erheblich. Es gibt deshalb Ansätze, zum Abschneiden spezielle Werkzeuge einzusetzen, bzw. diesen Vorgang zu automatisieren:

Die EP 0 861 813 B1 (Bottero) betrifft eine Schneidvorrichtung zum Abschneiden eines Umfangsabschnitts einer flexiblen Schicht, der über eine Platte hinausragt, welche mit der Schicht beschichtet wird, z. B. zum Beschneiden von Zwischenschichten bei der Verbundglasherstellung. Die Vorrichtung umfasst eine motorgetriebene rotierende Schneidscheibe sowie Anschlagmittel für den Umfangsabschnitt, die tangential an einer Umfangsfläche der Schneidscheibe angeordnet sind und an der Schneidstelle eine Gegenkraft zur Kraft der Schneidscheibe ausüben. Die Anschlagmittel können eine drehbare Anschlagscheibe umfassen, deren Achse bevorzugt schräg zur Achse der Schneidscheibe 34 orientiert ist.

Die DE 34 28 547 C2 (Central Glass / Toray Engineering) betrifft ein Schneidgerät zum Abschneiden eines über den Flächenbereich von Plattenglasschichten hinausgehenden Aussensaums einer zwischen den Plattenglasschichten angeordneten Zwischenschicht aus PVB. Dazu wird eine längs des Umfangs der Glasschichten bewegbare Bandmessereinheit eingesetzt. Um ein Verwickeln des abgeschnittenen Aussensaums in die Umlaufscheiben der Bandmessereinheit zu verhindern, umfasst das Schneidgerät ein Gleitstück mit Abstreiferkante und Einrichtungen zum Abweisen des abgeschnittenen Aussensaums. Das Schneidgerät wird während des Abschneidens an der Aussenkante der Glasplattenschichten des Laminats entlang geführt.

Die EP 0 845 440 B1 (Central Glass) betrifft eine weitere Vorrichtung zum Abschneiden des Randbereichs einer Zwischenschicht einer laminierten Glasplatte. Die Vorrichtung umfasst einen Roboterarm mit einer Roboterhand, welche ein lösbares Schneidmesser hält; das Schneidmesser wird vom Randbereich der Glasplatte weg bewegt, wenn eine bestimmte Widerstandskraft überschritten wird.

Bei der Herstellung von festen Platten, insbesondere von Glasplatten, sind Grössentoleranzen im Bereich von 0.5 - 2 mm zu erwarten. Falls eine präzise Abtrennung der überstehenden Randbereiche erforderlich ist, muss das Abschneiden auf die Kante der jeweiligen Platte ausgerichtet werden. Bei all den erwähnten Verfahren kann sich nun aber das Problem stellen, dass die Kante der festen Platte nach der Lamination aufgrund der seitlich ausquellenden Laminierschichten, den verschiedenen Ausdehnungen der Schichten und/oder der Rückseitenfolie sowohl mechanisch als auch berührungsfrei nur noch schwer detektiert werden kann. Dies erschwert ein gleichmässiges Abschneiden des überstehenden Abschnitts in Bezug auf die feste Platte, insbesondere wenn das Abschneiden automatisiert erfolgen soll, und kann bei Kontakt des Schneidwerkzeugs mit der Platte (insbesondere mit gehärtetem Glas) zu übermässiger Abnutzung oder Beschädigung des Schneidwerkzeugs führen.

Dasselbe Problem stellt sich auch bei anderen Bearbeitungsvorgängen des laminierten Schichtsystems, welche in einem geometrischen Bezug zur Kante der festen Platte erfolgen sollen, z. B. wenn das Laminat mit einem Rahmen versehen werden soll oder wenn bestimmte Bauteile in vorgegebenen Abständen an- oder eingebaut werden sollen.

### Darstellung der Erfindung

Aufgabe der Erfindung ist es, ein dem eingangs genannten technischen Gebiet zugehörendes Verfahren und eine entsprechende Anlage zu schaffen, welche eine präzise Bearbeitung von Laminaten ermöglichen.

Die Lösung der Aufgabe ist durch die Merkmale des Anspruchs 1 definiert. Gemäss der Erfindung wird vor dem Laminationsschritt mindestens eine Ortsmarkierung an der festen Platte angebracht, und es wird mindestens ein Abstands- und/oder Winkelwert der festen Platte in Bezug auf die Ortsmarkierung bestimmt. Nach dem Laminationsschritt wird das Laminat bearbeitet, wobei das Laminat und ein Bearbeitungswerkzeug in Abhängigkeit der Ortsmarkierung und des mindestens einen Abstands- und/oder Winkelwerts automatisch relativ zueinander positioniert werden.

Bei einem Abstandswert kann es sich beispielsweise um einen Abstand einer Kante bzw. einer Ecke von der Ortsmarkierung handeln. Die Werte können auch in einem Koordinationssystem gemessen werden, das durch die Ortsmarkierung bzw. mehrere Ortsmarkierungen definiert wird. Ein Winkelwert ergibt sich aus einem Winkel zwischen zwei Geraden, die durch die feste Platte und/oder die Ortsmarkierungen definiert sind oder sich aus dem Koordinatensystem ergeben.

Vor der Lamination lässt sich die feste Platte ohne weiteres vermessen, ihre Kante ist sowohl mechanisch (z. B. durch einen Fühler) als auch berührungsfrei (z. B. optisch mittels einer Kamera) detektierbar, und es lassen sich gängige, insbesondere automatisierte Verfahren zur Vermessung einsetzen. Nach der Lamination ist die Erfassung der Kanten der festen Platte erschwert oder praktisch verunmöglicht. Nun kann aber im Rahmen der Erfindung die Bearbeitung gestützt auf die angebrachten Ortsmarkierungen und den erfassten Abstands- und/oder Winkelwert (bzw. eine Mehrzahl solcher Werte) erfolgen. Es ist somit nicht mehr notwendig, die Kante der festen Platte nach der Lamination noch zu detektieren.

Eine erfindungsgemässe Anlage zum Bearbeiten eines Laminats, welches mindestens eine feste Platte, insbesondere eine Glasplatte, aufweist, umfasst entsprechend
a) eine Markierstation zum Anbringen einer Ortsmarkierung an der festen Platte;
b) eine Messstation zum Bestimmen mindestens eines Abstands- und/oder Winkelwerts der festen Platte in Bezug auf die Ortsmarkierung;
c) eine Laminierstation zum Laminieren des Laminats, welche der Markierstation und der Messstation nachgeordnet ist; und
d) mindestens eine Bearbeitungsstation, welche der Laminierstation nachgeordnet ist, mit einem Bearbeitungswerkzeug, wobei das Bearbeitungswerkzeug und das Laminat in Abhängigkeit der Ortsmarkierung und des mindestens einen Abstands- und/oder Winkelwerts automatisch relativ zueinander positionierbar sind.

Die Markierstation und die Messstation können konstruktiv in einer einzigen Station (Markier- und Messstation) integriert sein, es können aber auch zwei hintereinander angeordnete Stationen vorhanden sein.

Die Ortsmarkierung kann durch verschiedene (an sich bekannte) Verfahren aufgebracht werden. So ist es bekannt, Beschriftungen und Markierungen im Innern von Glassubstraten mittels fokussierter Laserstrahlung zu erzeugen (vgl. Lenk, A.; Morgenthal, L.: Damage-free micromarking of glass. Glastechn. Ber. Glass Sci. Technol. 73 (2000) No.9, 285 - 289). Diese Verfahren bieten den Vorteil, dass keine zusätzlichen Stoffe eingesetzt werden müssen, die damit erzeugten Markierungen sind zudem äusserst verschleisssicher.

Eine weitere Möglichkeit bietet der Tintenstrahldruck (Inkjet), eine etablierte Technologie zur Erzeugung von Markierungen auf Glas- und anderen festen Oberflächen. Im Rahmen des erfindungsgemässen Verfahrens besonders bevorzugt sind aber die unter den Markennamen MarcColor® bzw. UniColor® von der Firma boraglas GmbH, Halle (Deutschland) angebotenen Technologien, siehe auch WO 07/031151 A1, WO 07/062860 A1 und EP 1 728 770 A2 (alle boraglas GmbH). Bei diesen wird ein Spendermedium auf die Glasoberfläche aufgebracht. Beim erstgenannten Verfahren wird mittels fokussierter Laserstrahlung ein lonenaustausch induziert, Silberionen diffundieren in das Glas hinein und lagern sich zu Silbernanopartikeln im Innern des Glases zusammen. Beim zweitgenannten Verfahren wird mit Hilfe von Laserstrahlung am Übergang vom Spendermedium zur Glasoberfläche eine glasartige Schicht mit Silbernanopartikeln gebildet.

Weitere Technologien zur Markierung, wie z. B. das ortsgenaue Aufbringen eines Aufklebers, sind im Rahmen der Erfindung ebenfalls einsetzbar. Neben optisch lesbaren Markierungen, die eine besonders hohe Positionsgenauigkeit ermöglichen, sind auch beispielsweise induktiv oder kapazitiv erfassbare Markierungen denkbar.

Bevorzugt werden an der festen Platte zwei voneinander distanzierte Ortsmarkierungen angebracht, so dass auf deren Basis sowohl die Positionierung als auch die Orientierung der festen Platte stets eindeutig ermittelbar ist.

Um die zwei (oder mehr) Ortsmarkierungen anzubringen, kann die Markierstation einen beweglich angeordneten Markierkopf umfassen, der sich an die entsprechenden Positionen bewegen lässt.

Alternativ wird die zu markierende Platte relativ zu einer Markiervorrichtung bewegt.

Das erfindungsgemässe Verfahren eignet sich besonders zum Abtrennen eines überstehenden Abschnitts einer Schicht des Laminats, insbesondere einer Rückseitenfolie, wobei im Rahmen des Bearbeitungsschritts das Laminat und ein Trennwerkzeug zum Abtrennen des überstehenden Abschnitts in Abhängigkeit der Ortsmarkierung und des mindestens einen Abstands- und/oder Winkelwerts automatisch relativ zueinander positioniert werden.

Das Abtrennen der Rückseitenfolie (welche z. B. aus Polyester oder Polyvinylfluorid hergestellt ist) stellt dabei andere Anforderungen als das Abtrennen von zwischen zwei Glasplatten (und allenfalls weiteren Schichten) eingeschlossenen Laminat-Zwischenschichten.

Dazu ist die Bearbeitungsstation als Schneidstation ausgebildet und umfasst ein Trennwerkzeug zum Abtrennen des überstehenden Abschnitts. Das Laminat und das Trennwerkzeug sind in Abhängigkeit der Ortsmarkierung und des mindestens einen Abstands- und/oder Winkelwerts automatisch relativ zueinander positionierbar. Dabei kann das Schneidwerkzeug beweglich ausgebildet sein und/oder die Schneidstation umfasst eine bewegliche Halteeinrichtung für das Laminat.

Bei einer bevorzugten Ausführungsform der Schneidstation umfasst das Trennwerkzeug ein rotierendes Schneidmesser. Dieses wird für den Schneidvorgang derart in Rotation versetzt, dass seine Umfangsgeschwindigkeit grösser ist als die Relativgeschwindigkeit zwischen Laminat und Trennwerkzeug. Das Schneidmesser kann mit einer Stützrolle zusammenwirken, die auf der gegenüberliegenden Seite des Laminats aufliegt. Eine seitliche Abstützung des Trennwerkzeugs an der unregelmässigen Begrenzung des Laminats oder an der festen Platte ist nicht notwendig.

Alternativ sind andere Trennwerkzeuge einsetzbar, z. B. stationär am Trennwerkzeug angeordnete Schneidmesser oder Trennwerkzeuge, welche mit Wärme auf den abzutrennenden Abschnitt einwirken, z. B. mit Heizeinrichtungen versehene Messer oder Laserschneider.

Neben dem Abtrennen des überstehenden Abschnitts können die erzeugten Markierungen und die ermittelten Winkel- und/oder Abstandswerte auch für weitere Bearbeitungsschritte heranzogen werden, z. B. zum Rahmen des Laminats oder zum ortsgenauen Anbringen von weiteren Elementen am Laminat.

Vorzugsweise wird im Rahmen des erfindungsgemässen Verfahrens eine weitere Markierung zur Identifikation des Laminats an der festen Platte angebracht. Dabei kann es sich insbesondere um eine datencodierende Markierung, z. B. einen Barcode oder eine zweidimensionale Datenmatrix, oder um eine Markierung in Klartext handeln. Diese kann der Platte einen (zumindest für den Verarbeitungsprozess) eindeutigen Identifikationscode zuordnen, durch welchen die Platte (und später das Laminat, in welchem die Platte aufgenommen ist) in späteren Schritten stets zweifelsfrei identifiziert werden kann. Die weitere Markierung wird mit Vorteil im gleichen Arbeitsgang aufgebracht wie die Ortsmarkierungen. Sie ist vorzugsweise optisch lesbar, es kann sich dabei aber auch beispielsweise um einen RFID-Tag handeln.

Alternativ wird auf eine derartige Markierung verzichtet und die Anlage zur Bearbeitung des Laminats umfasst ein System zum Verfolgen der Werkstücke, so dass beim späteren Bearbeitungsvorgang ermittelbar ist, um welches der vorher markierten und vermessenen Werkstück es sich handelt.

Mit Vorteil wird der mindestens eine Abstand- und/oder Winkelwert nach seiner Bestimmung zusammen mit einer Identifikation des Laminats in einer zentralen Datenbank erfasst. Zum Bearbeiten des Laminats wird er dann wieder aus dieser zentralen Datenbank ausgelesen.

Alternativ werden die ermittelten Messwerte direkt auf dem Laminat gespeichert, z. B. indem eine entsprechend codierte Markierung (z. B. eine zweidimensionale Datenmatrix) erzeugt wird oder mittels eines RFID-Tags. Die Messwerte können dann bei einer späteren Bearbeitungsstation direkt ausgelesen werden.

In einem bevorzugten Ausführungsbeispiel ist das Laminat im Wesentlichen rechteckig, und zur Bestimmung des mindestens eines Abstands- und/oder Winkelwerts wird eine Kamera eingesetzt, welche einen Eckbereich der festen Platte erfasst. Die Ecken einer rechteckigen Platte lassen sich in der Regel einfach erfassen, ihre Position bezüglich einer Markierung lässt sich durch zwei Zahlen eindeutig bestimmen, zudem kann auch der effektive Winkel bestimmt werden. Bei der Herstellung von Glasplatten sind die wellenartigen Abweichungen der Aussenkanten im Vergleich zu den weiteren Abweichungen von der exakten Rechteckform um mindestens eine Grössenordnung geringer. Durch die Positionen aller vier Ecken ist somit die Geometrie der Kontur des im Wesentlichen rechteckigen Laminats bis auf die untergeordneten wellenartigen Abweichungen eindeutig bestimmt. Bei der Verwendung einer Kamera ist es von Vorteil, wenn die Ortsmarkierungen derart im Eckbereich der Platte angeordnet sind, dass sowohl die Ecke der festen Platte als auch die jeweilige Ortsmarkierung gleichzeitig im Aufnahmefeld der Kamera sichtbar sind, so dass der entsprechende Abstands- und/oder Winkelwert aus einer einzigen Aufnahme bestimmt werden kann.

Eine präzise Bearbeitung des Laminats kann insbesondere erreicht werden, wenn bei der Bearbeitung eines flächigen Laminats, welches eine im Wesentlichen polygonale Form hat, eine Anzahl von Abstands- und/oder Winkelwerten bestimmt wird, die ausreicht, um eine polygonale Kontur des Laminats sowie einen Ortsbezug und eine Orientierung dieser Kontur zu mindestens zwei Ortsmarkierungen an der festen Platte eindeutig zu definieren. Wenn man die Welligkeit der Konturen (siehe oben) sowie Abweichungen in der dritten Dimension vernachlässigt, reichen beispielsweise bei einem viereckigen Laminat somit die Flächenkoordinaten der vier Eckpunkte in Bezug auf das von zwei Ortsmarkierungen aufgespannte (flächige) Koordinatensystem zur eindeutigen Definition der Viereckform aus.

Mit Vorteil umfasst somit die Messstation vier feste Kameras zum gleichzeitigen Ausmessen von vier Eckbereichen einer im Wesentlichen rechteckigen festen Platte. Steht eine solche Anzahl von Kameras zur Verfügung, erübrigen sich in der Messstation Relativbewegungen zwischen Platte und Erfassungseinrichtung. Die Erfassung kann somit präzise und schnell erfolgen. Einige oder alle Kameras können selbstverständlich beweglich in der Messstation angeordnet sein, so dass hintereinander verschieden grosse Laminate verarbeitbar sind. Um mit dieser Ausführungsform ein Laminat im Rahmen der erforderlichen Informationen vollständig zu vermessen, sind aber keine Bewegungen der Kameras oder der Platte notwendig.

Falls erforderlich, kann auch nach dem Laminationsschritt noch eine Positionsbestimmung am Laminat vorgenommen werden, insbesondere eine, bei welcher die Kante der festen Platte keine Rolle spielt. Die entsprechend bestimmte Position wird in Bezug auf die Ortsmarkierung an der festen Platte erfasst, und in einem nachfolgenden Bearbeitungsschritt werden das Laminat und das Bearbeitungswerkzeug in Abhängigkeit der Ortsmarkierung und der in Bezug auf die Ortsmarkierung erfassten Position relativ zueinander positioniert. In der als EP 08 405 123.4 am 30. April 2008 eingereichten Anmeldung derselben Anmelderschaft, deren Inhalt hiermit in die vorliegende Anmeldung aufgenommen ist, ist beispielsweise ein Verfahren zum Setzen einer Anschlussdose an ein Solarpanel beschrieben. Im Rahmen dieses Verfahrens wird die Position von innerhalb des Laminats befindlichen Kontaktbereichen bestimmt, z. B. mittels eines induktiven Sensors. Anschliessend werden diese Kontaktbereiche freigelegt und eine Anschlussdose wird derart auf die Rückseite des Solarpanels gesetzt, dass Anschlussfahnen der Anschlussdose die freigelegten Kontaktbereiche kontaktieren. Im Rahmen der vorliegenden Erfindung können nun die Positionen der Kontaktbereiche in Bezug auf die früher erzeugten Ortsmarkierungen ermittelt werden. Das Freilegen der Kontaktbereiche und/oder das Setzen der Anschlussdose kann in der Folge in Bezug auf die Ortsmarkierungen erfolgen, gestützt auf die entsprechend ermittelten Positionen.

Mit Vorteil umfasst die Bearbeitungsstation einen Drehtisch zur Aufnahme des Laminats, mit welchem eine Winkelkorrektur des Laminats in Abhängigkeit der Ortsmarkierung und des mindestens einen Abstands- und/oder Winkelwerts vornehmbar ist. Ein solcher Drehtisch ermöglicht eine einfache und schnelle Winkelkorrektur. Er kann zusätzlich mit Einrichtungen zur Quer- und/oder Längsverschiebung des Laminats sowie mit einer Haltevorrichtung für das Laminat (z. B. einer Unterdruckeinrichtung oder Klemmvorrichtungen) versehen sein.

Mit Vorteil umfasst die Bearbeitungsstation mindestens eine Kamera zum Erfassen der Ortsmarkierung. Kameras sind kostengünstig und flexibel einsetzbar. Sie ermöglichen eine präzise Erfassung von optisch lesbaren Ortsmarkierungen. Falls beispielsweise zwei Ortsmarkierungen sowie eine Markierung zur Identifikation vorgesehen sind, kann eine einzige zu den verschiedenen Markierungen bewegbare Kamera vorhanden sein, oder es sind zwei während des Erfassungsprozesses feststehende Kameras vorhanden, und die Markierung zur Identifikation ist benachbart zu einer Ortsmarkierung angeordnet (bzw. dient gleichzeitig als Ortsmarkierung), damit eine der beiden Kameras die Ortsmarkierung und die Identifikation gleichzeitig erfassen kann.

Aus der nachfolgenden Detailbeschreibung und der Gesamtheit der Patentansprüche ergeben sich weitere vorteilhafte Ausführungsformen und Merkmalskombinationen der Erfindung.

### Kurze Beschreibung der Zeichnungen

Die zur Erläuterung des Ausführungsbeispiels verwendeten Zeichnungen zeigen:
- Fig. 1: Eine schematische Blockdarstellung einer erfindungsgemässen Anlage zur Herstellung von Solarpanels;
- Fig. 2: eine schematische Darstellung der Markier- und Messstation der Anlage;
- Fig. 3: eine schematische Darstellung der erzeugten Markierungen;
- Fig. 4: eine schematische Darstellung der Schneidstation der Anlage;
- Fig. 5: einen schematischen Querschnitt durch das Schneidwerkzeug und die bearbeitete Randregion des Laminats; und
- Fig. 6A-C: eine schematische Darstellung des Verfahrens zum Abschneiden des überstehenden Randbereichs der Rückseitenfolie.
Grundsätzlich sind in den Figuren gleiche Teile mit gleichen Bezugszeichen versehen.

### Wege zur Ausführung der Erfindung

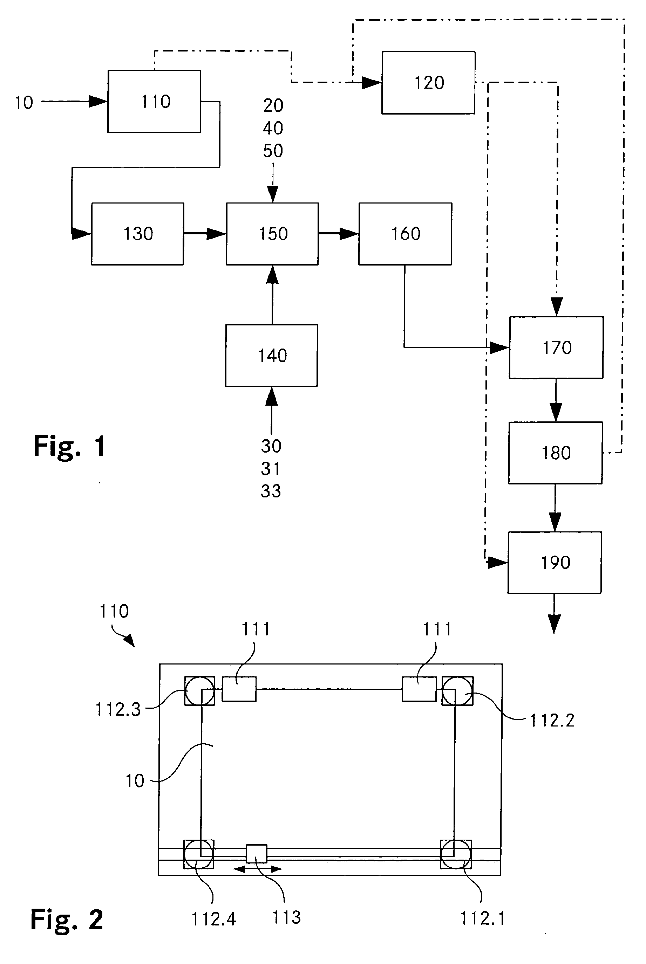

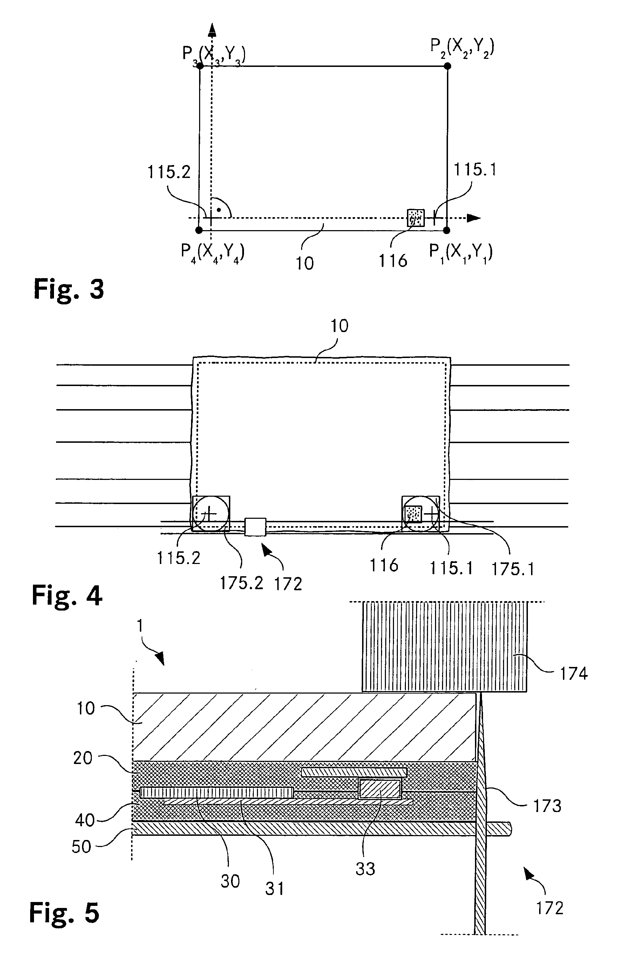

Die Figur 1 ist eine schematische Blockdarstellung einer erfindungsgemässen Anlage zur Herstellung von Solarpanels. Das Solarpanel 1 (vgl. Figur 5) umfasst als Grundsubstrat eine im Wesentlichen rechteckige Glasplatte 10 aus Einscheiben-Sicherheitsglas. Auf dieser ist ein Schichtsystem aus einer ersten transparenten Kunststoffschicht 20 aus Ethylenvinylacetat (EVA), einer Mehrzahl von an sich bekannten Solarzellen 30, einer zweiten Kunststoffschicht 40 aus Ethylenvinylacetat (EVA) sowie einer Rückseitenfolie 50 aus Polyester aufgebaut. Die Solarzellen sind durch Längsverbinder 31 und Querverbinder 33 in an sich bekannter Weise elektrisch miteinander verbunden.

Das Solarpanel 1 wird derart angeordnet (z. B. auf einem Gebäudedach befestigt), dass die Glasplatte 10 der Sonne zugewandt ist. Die Sonnenstrahlung tritt durch die Glasplatte 10 sowie die erste transparente Kunststoffschicht 20 hindurch und trifft auf die zwischen den Kunststoffschichten 20, 40 eingebetteten Solarzellen 30, wo eine elektrische Spannung erzeugt wird.

Zur Fertigung des Solarpanels 1 wird die Glasplatte 10 in einer Markier- und Messstationen 110 zunächst mit zwei Ortsmarkierungen versehen und vermessen. Die Messdaten werden zu einer zentralen Datenbank 120, welche Teil einer Anlagesteuerung ist, übertragen und darin abgelegt. In einer weiteren Station 130 wird die Glasplatte 10 gereinigt und für die weiteren Verfahrensschritte vorbereitet. In einer weiteren Station 140 werden die Solarzellen 30 zunächst mit den Längsverbindern 31 zu Strängen verbunden, anschliessend werden die Stränge mittels der Querverbinder 33 zusammengeschaltet. Anschliessend wird in einer weiteren Station 150 das Schichtsystem schrittweise auf die Glasplatte 10 aufgelegt, d. h. eine erste Kunststofffolie aus EVA zur Bildung der ersten Kunststoffschicht 20, die zusammengeschalteten Solarzellen 30 mitsamt Längs- und Querverbindern 31, 33, eine zweite Kunststofffolie zur Bildung der zweiten Kunststoffschicht 40 und die Rückseitenfolie 50 werden auf die Glasplatte 10 gelegt. Als nächstes erfolgt in einer Laminationseinrichtung 160 das Laminieren des Moduls bei Unterdruck und ca. 150 °C. Beim Laminieren bilden sich aus den bis dahin milchigen EVA-Kunststofffolien klare, dreidimensional vernetzte und nicht mehr aufschmelzbare Kunststoffschichten 20, 40, in der die Solarzellen 30 und die Verbinder nun eingebettet sind und die fest untereinander sowie mit der Glasplatte 10 und der Rückseitenfolie 50 verbunden sind. Die EVA-Schichten quellen leicht über den Aussenrand der Glasplatte 10 nach aussen.

Nach dem Laminieren werden in einer Schneidstation 170 die Kanten gesäumt, anschliessend werden in der nächsten Station 180 die Kontaktbereiche der Querverbinder 33 freigelegt und schliesslich wird in einer weiteren Station 190 eine Anschlussdose gesetzt. In der Folge kann das Solarpanel 1 noch gerahmt und vermessen und nach seinen elektrischen Werten klassifiziert und verpackt werden.

Die Figur 2 ist eine schematische Darstellung der Markier- und Messstation 110. Diese umfasst eine Auflage, auf welche die Glasplatte 10 auflegbar ist sowie Haltevorrichtungen 111 zum Festhalten der Glasplatte 10. Vier Kameras 112.1...112.4 sind derart an der Markier- und Messstation 110 angeordnet, dass ihre Aufnahmefelder die vier Eckregionen der Glasplatte 10 erfassen können. An der den Haltevorrichtungen 111 gegenüberliegenden Längsseite der Auflage ist ein Markierkopf 113 entlang der Längsseite der aufgelegten Glasplatte 10 linear verfahrbar angeordnet.

Zum Erzeugen der gewünschten Markierungen wird das Verfahren UniColor® der Firma boraglas GmbH (siehe oben) eingesetzt. Dazu wird zunächst an den entsprechenden Stellen das Spendermedium auf die Glasoberfläche aufgebracht, z. B. als Folie aufgeklebt, wonach mittels eines im Markierkopf 113 untergebrachten Lasers die zu markierenden Stellen lokal erwärmt werden. Unter dem Einfluss der Laserstrahlung entsteht eine glasartige Schicht mit Silbernanopartikeln auf der Glasoberfläche.

In der nachfolgenden Station 130 findet eine Reinigung der Glasplatte 10 statt, wodurch auch allenfalls im Rahmen des Markierens entstandene Verunreinigungen oder Schmauchspuren entfernt werden.

Die Figur 3 ist eine schematische Darstellung der erzeugten Markierungen. Diese umfassen zwei Ortsmarkierungen 115.1, 115.2, jeweils in der Form eines Kreuzes, welche in zwei Eckbereichen einer der Längsseiten der Glasplatte 10 erzeugt worden sind. Benachbart zur vorderen Ortsmarkierung 115.1 ist eine zweidimensionale Datenmatrix 116 auf dieselbe Weise auf die Glasoberfläche aufgebracht worden. Sie codiert eine eindeutige Identifikationsnummer für die Glasplatte 10. Durch die zwei Ortsmarkierungen 115.1, 115.2 wird ein zweidimensionales kartesisches Koordinatensystem definiert, dessen Ursprung durch die hintere Ortsmarkierung 115.2 gegeben ist. Die x-Achse verläuft vom Ursprung durch die vordere Ortsmarkierung 115.1, die y-Achse ist im Gegenuhrzeigersinn um 90° zur x-Achse gedreht. Jeder der vier von den Kameras 112.1...112.4 erfassten Eckpunkte P₁...P₄ lässt sich durch ein XY-Koordinatenpaar in diesem Koordinatensystem darstellen. Es ist anzumerken, dass die x-Achse nicht notwendigerweise parallel zur Längsseite der Glasplatte 10 verlaufen muss, d. h. die Ortsmarkierungen 115.1, 115.2 müssen nicht denselben Abstand von der Längsseite der Platte haben. Es ist für das Funktionieren der Erfindung weitgehend unerheblich, wo die beiden Ortsmarkierungen angebracht sind. Im Sinn einer guten Präzision ist es aber von Vorteil, wenn ihr Abstand ausreichend gross ist.

Die Figur 4 ist eine schematische Darstellung der Schneidstation 170. Diese umfasst einen Drehtisch 171, auf welchen das Solarpanel 1 aufgelegt werden kann. Wie aus der Figur 4 ersichtlich ist, ragen Abschnitte der Rückseitenfolie (und gegebenenfalls auch der Laminierschichten) über die Glasplatte 10 hinaus. Saugvorrichtungen (nicht dargestellt) halten das Solarpanel 1 auf der Auflagefläche des Drehtisches 171 fest. Der Drehtisch 171 ermöglicht in an sich bekannter Weise beliebige Drehbewegungen des Solarpanels 1 sowie eine Querverschiebung desselben. An einer Längsseite des Drehtisches 171 ist ein längsverschiebbares Schneidwerkzeug 172 angeordnet. Die Schneidstation verfügt ausserdem über zwei Kameras 175.1, 175.2, welche ebenfalls im Bereich dieser Längsseite angeordnet sind und deren Abstand derart eingestellt ist, dass sie die beiden Ortsmarkierungen 115.1, 115.2 sowie die Datenmatrix 116 erfassen können. Die vordere Kamera 175.1 erfasst dabei in ihrem Aufnahmefeld gleichzeitig die vordere Ortsmarkierung 115.1 und die daneben angeordnete Datenmatrix 116.

Die Figur 5 zeigt einen schematischen Querschnitt durch das Schneidwerkzeug 172 und die bearbeitete Randregion des Laminats 1. Das Schneidwerkzeug umfasst ein an sich bekanntes, kreisförmiges rotierendes Schneidmesser 173 und eine Stützrolle 174, die auf der der Drehachse des Schneidmessers 173 gegenüberliegenden Hauptseite des Laminats 1 abgestützt ist. Das Schneidmesser 173 ist derart ausgebildet, dass über die Glasplatte 10 hinausragende Abschnitte der Rückseitenfolie 50 sowie der Laminierfolien 20, 40 abgetrennt werden können.

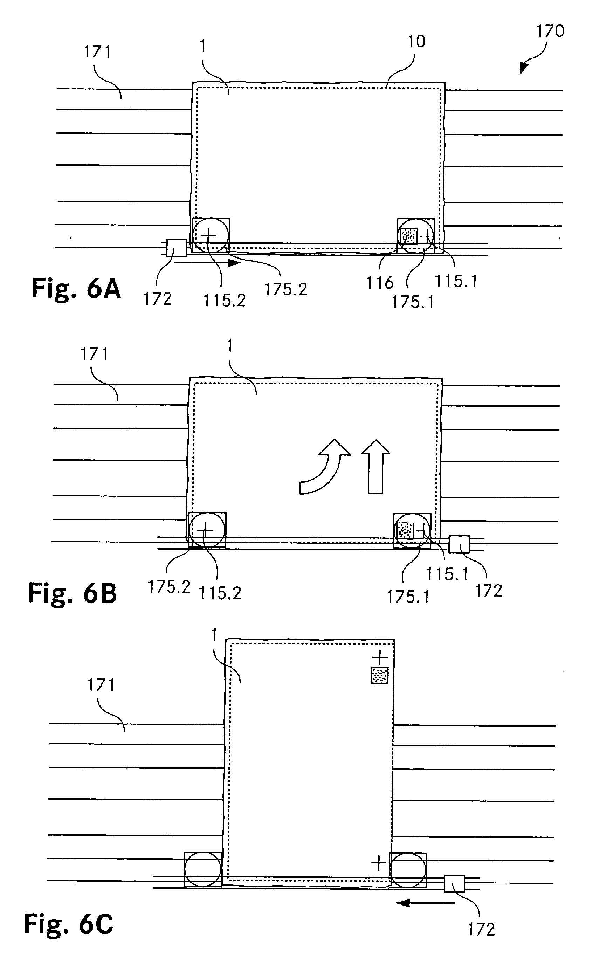

Die Figuren 6A-C dienen zur Darstellung des Verfahrens zum Abschneiden des überstehenden Randbereichs der Rückseitenfolie. Das Laminat 1 wird zunächst so auf dem Drehtisch 171 positioniert, dass die beiden Ortsmarkierungen 115.1, 115.2 sowie die Datenmatrix 116 von den beiden an der Schneidstation 170 angeordneten Kameras 175.1, 175.2 erfasst werden können. Die eine Längsseite des Laminats 1 befindet sich somit ungefähr parallel zu demjenigen Rand der Auflage des Drehtischs 171, welcher mit den beiden Kameras 175.1, 175.2 versehen ist (siehe Figur 6A). Die aus der Datenmatrix 116 ausgelesenen Identifikationsinformationen werden an die Datenbank gesandt, worauf diese die zur Platte 10 des Laminats 1 erfassten Messdaten an die Schneidstation 170 zurückgibt. Mit Hilfe des Drehtischs 171 wird dann aufgrund der erhaltenen Messdaten und den Ortsmarkierungen 115.1, 115.2 das Laminat 1 derart positioniert, dass sich die gewünschte Schnittlinie mit dem Verfahrweg des Schneidwerkzeugs 172 deckt. Die Schnittlinie hat im dargestellten Ausführungsbeispiel einen Abstand von 0.1 - 0.2 mm von der Kante der Platte 10. Anschliessend werden die Saugvorrichtungen des Drehtischs 171 aktiviert, wodurch das Laminat 1 sicher auf der Auflage des Drehtischs 171 festgehalten wird. Durch eine Linearbewegung des Schneidwerkzeugs 172 wird dann der überstehende Abschnitt der Rückseitenfolie und gegebenenfalls der Laminierfolien abgetrennt, in der Figur 6B ist das Ergebnis dieses Schritts dargestellt.

Als nächstes wird nun, nach der Deaktivierung der Saugvorrichtungen, mit Hilfe des Drehtischs 171 das Laminat 1 um 90° gedreht und in Querrichtung verschoben, so dass eine Schmalseite des Laminats 1 an denjenigen Rand der Auflage des Drehtischs 171 grenzt, welcher mit den Kameras 175.1, 175.2 versehen ist. Die Positionierung des Laminats 1 erfolgt weiterhin auf der Basis der erfassten Messdaten, eine Erfassung der Ortsmarkierungen 115.1, 115.2 ist jedoch im weiteren Verlauf nicht mehr notwendig, da die weiteren Positionierschritte jeweils relativ zur vorherigen Position erfolgen. Nach der erfolgten Positionierung befindet sich das Laminat 1 wieder in einer derartigen Position, dass sich die gewünschte Schnittlinie entlang der Schmalseite mit dem Verfahrweg des Schneidwerkzeugs 172 deckt. Entsprechend kann durch eine Linearbewegung des Schneidwerkzeugs 172 wiederum der überstehende Abschnitt der Rückseitenfolie und gegebenenfalls der Laminierfolien abgetrennt werden.

Im weiteren Verlauf des Verfahrens (nicht dargestellt), erfolgen abermals zwei 90°-Drehungen des Laminats 1 gefolgt von entsprechenden Korrekturen der Querposition und dem Abschneidevorgang. Zuletzt wird das Laminat 1 wiederum um 90° gedreht, so dass es wieder seine Ausgangsposition auf dem Drehtisch 171 einnimmt und weiter befördert werden kann.

Die Erfindung ist nicht auf das dargestellte Ausführungsbeispiel beschränkt. So kann eine erfindungsgemässe Anlage weitere Stationen umfassen, oder einzelne der Stationen können fehlen. Die Geometrie der Haltevorrichtungen und Transportvorrichtungen für die Glasplatte bzw. für das Laminat sowie die Anzahl und Anordnung der Kameras können unterschiedlich gewählt werden. Entsprechend kann auch die Position oder die Art der Markierungen unterschiedlich sein, so sind andersartige Ortsmarkierungen denkbar, oder die Markierung zur Identifikation ist ein Barcode anstelle einer Datenmatrix. Die verwendeten Abstands- bzw. Winkelwerte und das entsprechende Koordinatensystem können ebenfalls anders gewählt werden. So können bei einer Abwandlung des Ausführungsbeispiels anstelle der vier Datenpaare im kartesischen Koordinatensystem beispielsweise kombinierte Abstands- und Winkelwerte verwendet werden, z. B. Polarkoordinaten.

Bei Relativbewegungen zwischen der Glasplatte bzw. dem Laminat einerseits und einer Bearbeitungsvorrichtung (z. B. Markierkopf, Schneidvorrichtung) andererseits kann stets jeweils die Glasplatte oder die Bearbeitungsvorrichtung bewegt werden. Zur Beschleunigung des Abschneidevorangs können zwei einander gegenüberliegende Schneidvorrichtungen vorgesehen sein, die gleichzeitig überstehende Abschnitte auf zwei gegenüberliegenden Seiten des Laminats abtrennen können. Die Schneidvorrichtung kann zudem konstruktiv anders ausgebildet sein.

Zusammenfassend ist festzustellen, dass durch die Erfindung ein Verfahren und eine Anlage geschaffen werden, welche eine präzise Bearbeitung von Laminaten ermöglichen.

## Patentansprüche

1. Verfahren zum Bearbeiten eines Laminats (1), welches mindestens eine feste Platte, insbesondere eine Glasplatte (10), aufweist, umfassend folgende Schritte:
a) vor einem Laminationsschritt Anbringen mindestens einer Ortsmarkierung (115.1, 115.2) an der festen Platte (10) und Bestimmung mindestens eines Abstands- und/oder Winkelwerts der festen Platte (10) in Bezug auf die Ortsmarkierung (115.1, 115.2);
b) nach dem Laminationsschritt Bearbeiten des Laminats (1), wobei das Laminat (1) und ein Bearbeitungswerkzeug (172) in Abhängigkeit der Ortsmarkierung (115.1, 115.2) und des mindestens einen Abstands- und/oder Winkelwerts automatisch relativ zueinander positioniert werden.

2. Verfahren nach Anspruch 1 zum Abtrennen eines überstehenden Abschnitts einer Schicht (50) des Laminats, insbesondere einer Rückseitenfolie, wobei im Rahmen des Bearbeitungsschritts das Laminat (1) und ein Trennwerkzeug (172) zum Abtrennen des überstehenden Abschnitts in Abhängigkeit der Ortsmarkierung (115.1, 115.2) und des mindestens einen Abstands- und/oder Winkelwerts automatisch relativ zueinander positioniert werden.

3. Verfahren nach Anspruch 1 oder 2, **dadurch gekennzeichnet, dass** eine weitere Markierung (116) zur Identifikation des Laminats an der festen Platte angebracht wird.

4. Verfahren nach einem der Ansprüche 1 bis 3, **dadurch gekennzeichnet, dass** der mindestens eine Abstand- und/oder Winkelwert nach seiner Bestimmung zusammen mit einer Identifikation des Laminats (1) in einer zentralen Datenbank (120) erfasst und zum Bearbeiten des Laminats (1) aus dieser zentralen Datenbank (120) ausgelesen wird.

5. Verfahren nach einem der Ansprüche 1 bis 4, **dadurch gekennzeichnet, dass** das Laminat (1) im Wesentlichen rechteckig ist und dass zur Bestimmung des mindestens eines Abstands- und/oder Winkelwerts eine Kamera (112.1 ... 12.4) eingesetzt wird, welche einen Eckbereich der festen Platte (1) erfasst.

6. Verfahren nach einem der Ansprüche 1 bis 5, **dadurch gekennzeichnet, dass** bei der Bearbeitung eines flächigen Laminats (1), welches eine im Wesentlichen polygonale Form hat, eine Anzahl von Abstands- und/oder Winkelwerten bestimmt wird, die ausreicht, um eine polygonale Kontur des Laminats (1) sowie einen Ortsbezug und eine Orientierung dieser Kontur zu mindestens zwei Ortsmarkierungen (115.1, 115.2) an der festen Platte (10) eindeutig zu definieren.

7. Verfahren nach einem der Ansprüche 1 bis 6, **dadurch gekennzeichnet, dass** nach dem Laminationsschritt eine Positionsbestimmung am Laminat vorgenommen wird, dass die bestimmte Position in Bezug auf die Ortsmarkierung an der festen Platte erfasst wird und dass in einem nachfolgenden Bearbeitungsschritt das Laminat und das Bearbeitungswerkzeug in Abhängigkeit der Ortsmarkierung und der in Bezug auf die Ortsmarkierung erfassten Position relativ zueinander positioniert werden.

8. Anlage zum Bearbeiten eines Laminats (1), welches mindestens eine feste Platte (10), insbesondere eine Glasplatte, aufweist, umfassend:
a) eine Markierstation (110) zum Anbringen einer Ortsmarkierung (115.1, 115.2) an der festen Platte (10);
b) eine Messstation (110) zum Bestimmen mindestens eines Abstands- und/oder Winkelwerts der festen Platte (10) in Bezug auf die Ortsmarkierung (115.1, 115.2);
c) eine Laminierstation (160) zum Laminieren des Laminats (1), welche der Markierstation und der Messstation (110) nachgeordnet ist; und
d) mindestens eine Bearbeitungsstation (170), welche der Laminierstation (160) nachgeordnet ist, mit einem Bearbeitungswerkzeug (172), wobei das Bearbeitungswerkzeug (172) und das Laminat (1) in Abhängigkeit der Ortsmarkierung (115.1, 115.2) und des mindestens einen Abstands- und/oder Winkelwerts automatisch relativ zueinander positionierbar sind.

9. Anlage nach Anspruch 8, **dadurch gekennzeichnet, dass** die Markierstation (110) einen beweglich angeordneten Markierkopf (113) zum Anbringen von mindestens zwei Ortsmarkierungen (115.1, 115.2) an der festen Platte (10) umfasst.

10. Anlage nach Anspruch 8 oder 9, **dadurch gekennzeichnet, dass** die Messstation (110) vier feste Kameras (12.1...112.4) zum gleichzeitigen Ausmessen von vier Eckbereichen einer im Wesentlichen rechteckigen festen Platte (10) umfasst.

11. Anlage nach einem der Ansprüche 8 bis 10, **dadurch gekennzeichnet, dass** die Bearbeitungsstation (170) einen Drehtisch (171) zur Aufnahme des Laminats (1) umfasst, mit welchem eine Winkelkorrektur des Laminats (1) in Abhängigkeit der Ortsmarkierung (115.1, 115.2) und des mindestens einen Abstands- und/oder Winkelwerts vornehmbar ist.

12. Anlage nach einem der Ansprüche 8 bis 11, **dadurch gekennzeichnet, dass** die Bearbeitungsstation (170) mindestens eine Kamera (175.1, 175.2) zum Erfassen der Ortsmarkierung (115.1, 115.2) umfasst.

13. Anlage nach einem der Ansprüche 8 bis 12, **dadurch gekennzeichnet, dass** die Bearbeitungsstation (170) eine Schneidstation zum Abtrennen eines überstehenden Abschnitts einer Schicht (50) des Laminats (1), insbesondere einer Rückseitenfolie, ist, wobei die Schneidstation (170) ein Trennwerkzeug (172) zum Abtrennen des überstehenden Abschnitts umfasst und das Laminat (1) und das Trennwerkzeug (172) in Abhängigkeit der Ortsmarkierung (115.1, 115.2) und des mindestens einen Abstands- und/oder Winkelwerts automatisch relativ zueinander positionierbar sind.

14. Anlage nach Anspruch 13, **dadurch gekennzeichnet, dass** das Trennwerkzeug (172) ein rotierendes Schneidmesser (173) umfasst.
